# EUROPEAN PATENT APPLICATION

(11) **EP 4 852 664 A1**
(43) Date of publication of application: **09.12.2026**
(21) Application number: 26181726.6
(22) Date of filing: 28.05.2026
(51) Int. Cl.: H10F 19/90, H10F 77/20

(54) **SOLAR CELL, PHOTOVOLTAIC MODULE AND PRINTING SCREEN**

(30) Priority: 03.06.2025 CN 202510732888
(71) Applicant: Tongwei Solar (Chengdu) Co., Ltd., Chengdu, Sichuan 610299 (CN)
(72) Inventor: LIU, Luolin, Chengdu, Sichuan 610299 (CN); ZHU, Jiang, Chengdu, Sichuan 610299 (CN)
(74) Representative: Dehns Germany Partnerschaft mbB

(57) **Abstract**

The present invention relates to the technical field of solar cells, and in particular, to a solar cell, a photovoltaic module, and a printing screen. The solar cell includes a cell body, fingers and electrical connection portions. The cell body has a cell surface which includes a middle region and edge regions. The fingers include middle fingers and edge fingers disposed. The electrical connection portions include middle electrical connection portions and edge electrical connection portions. The edge electrical connection portions are respectively connected to the edge fingers, and a maximum size of each edge electrical connection portion in the first direction is D1; and the middle electrical connection portions are respectively connected to the middle fingers, and a maximum size of each middle electrical connection portion in the first direction is D2, and D1>D2.

## Description

### Technical Field

The present invention relates to the technical field of solar cells, and in particular, to a solar cell, a photovoltaic module and a printing screen.

### Background

During the process of manufacturing solar cells into a photovoltaic module, electrical connection portions on the solar cells need to be alloyed with conductive wires, so that the conductive wires are connected to the solar cells, therefore the solar cells are electrically connected by the conductive wires. However, the electrical connection portions at edge positions of the solar cells are easily disengaged from the conductive wires, thereby affecting the thermal cycle reliability and power of the photovoltaic module applying the solar cells.

### Summary

Embodiments of the present invention disclose a solar cell, a photovoltaic module and a printing screen, which are capable of reducing the phenomenon of edge electrical connection portions disengaging from conductive wires.

In order to achieve the above objective, in a first aspect, some embodiments of the present invention disclose a solar cell, including:
a cell body, having a cell surface, where the cell surface includes a middle region and edge regions disposed at opposite ends of the middle region in a first direction;
a plurality of fingers, spaced apart on the cell surface, where the first direction is a direction in which the plurality of fingers are disposed at intervals, and the plurality of fingers include a plurality of middle fingers disposed in the middle region and a plurality of edge fingers disposed in the edge regions; and
a plurality of electrical connection portions, including a plurality of middle electrical connection portions disposed in the middle region and a plurality of edge electrical connection portions disposed in the edge regions, where each of the plurality of edge electrical connection portions is respectively connected to at least one of the plurality of edge fingers, and a maximum size of at least one of the plurality of edge electrical connection portions in the first direction is D1; and each of the plurality of middle electrical connection portions is respectively connected to at least one of the plurality of middle fingers, a maximum size of at least one of the plurality of middle electrical connection portions in the first direction is D2, and D1>D2.

In some possible implementations of the first aspect, the plurality of edge electrical connection portions are disposed in at least one of the edge regions, and a plurality of edge electrical connection portions in a same edge region include a plurality of edge electrical connection portions spaced apart in a column along the first direction; and
among the plurality of edge electrical connection portions in the column, a part of the plurality of edge electrical connection portions in the column are first edge electrical connection portions, and an other part of the plurality of edge electrical connection portions in the column are second edge electrical connection portions, the second edge electrical connection portions are closer to the middle region than the first edge electrical connection portions, a maximum size of each of the first edge electrical connection portions in the first direction is D11, and a maximum size of each of the second edge electrical connection portions in the first direction is D12, where D11>D12.

In some possible implementations of the first aspect, the solar cell satisfies at least one of the following:
each of the first edge electrical connection portions is connected to some of the plurality of edge fingers spaced apart in the first direction;
in an edge region provided with edge electrical connection portions, a first edge electrical connection portion is an edge electrical connection portion farthest away from the middle region;
in an edge region provided with edge electrical connection portions, two second edge electrical connection portions are disposed;
the maximum size D11 of each of the first edge electrical connection portions in the first direction ranges from 0.5mm to 2mm;
the maximum size D12 of each of the second edge electrical connection portions in the first direction ranges from 0.2mm to 0.5mm.

In some possible implementations of the first aspect, at least one of the plurality of electrical connection portions is provided with at least one hollow portion, and the cell surface is exposed to a setting region of the at least one hollow portion.

In some possible implementations of the first aspect, each of the at least one hollow portion penetrates through a respective electrical connection portion in the first direction; and
a same electrical connection portion is provided with one or more hollow portions, in a case where a plurality of hollow portions are disposed on the same electrical connection portion, the plurality of hollow portions are spaced apart in a second direction, and the second direction intersects with the first direction.

In some possible implementations of the first aspect, the solar cell satisfies at least one of the following:
a size D3 of a hollow portion in the second direction ranges from 0.1mm to 0.5mm, and the first direction is perpendicular to the second direction;
the same electrical connection portion is provided with 2 to 5 hollow portions;
the at least one hollow portion is disposed on the plurality of edge electrical connection portion.

In some possible implementations of the first aspect, at least one of the plurality of electrical connection portions includes edges, at least one of which is a concave-convex edge.

In some possible implementations of the first aspect, the solar cell satisfies at least one of the following:
at least one of the plurality of edge electrical connection portions includes edges spaced apart in the first direction, at least one of which is the concave-convex edge; and
the concave-convex edge is sawtooth-shaped or curve-shaped.

In some possible implementations of the first aspect, each of the plurality of fingers is of an intermittent structure or a continuous structure;
in a case where a finger is of the continuous structure, the finger being of the continuous structure extends in a second direction and penetrates through an electrical connection portion connected to the finger, and the second direction intersects with the first direction; and
in a case where a finger is of the intermittent structure, the finger being of the intermittent structure includes a plurality of sub-fingers spaced apart in the second direction, each of the plurality of sub-fingers extends in the second direction, and ends of two adjacent sub-fingers close to each other are connected to a same electrical connection portion.

In some possible implementations of the first aspect, each of the plurality of fingers is of an intermittent structure or a continuous structure;
in a case where a finger is of the continuous structure, the finger being of the continuous structure extends in a second direction and penetrates through an electrical connection portion connected to the finger, and the second direction intersects with the first direction; and
in a case where a finger is of the intermittent structure, the finger being of the intermittent structure includes a plurality of sub-fingers spaced apart in the second direction, each of the plurality of sub-fingers extends in the second direction, and ends of two adjacent sub-fingers close to each other are connected to a same electrical connection portion.

In some possible implementations of the first aspect, the solar cell satisfies at least one of the following:
the plurality of middle electrical connection portions are respectively connected to the plurality of middle fingers in a one-to-one manner, and the plurality of middle electrical connection portions have a same size;
the size D2 of each of the plurality of middle electrical connection portions in the first direction ranges from 0.1mm to 0.3mm;
each of the plurality of electrical connection portions has a same size D4 in a second direction, and the second direction is perpendicular to the first direction;
a size D4 of each of the plurality of electrical connection portions in a second direction ranges from 0.5mm to 3mm, and the second direction is perpendicular to the first direction; and
each of the plurality of electrical connection portions is a bonding pad.

In some possible implementations of the first aspect, the solar cell satisfies at least one of the following:
the solar cell is a busbar-free solar cell; and
the solar cell is a back-contact solar cell, the cell surface is a backlight surface, a part of the plurality of fingers are positive-electrode fingers and an other part of the plurality of fingers are negative-electrode fingers, and the positive-electrode fingers and the negative-electrode fingers are alternately disposed in the first direction; a part of the plurality of electrical connection portions are positive-electrode electrical connection portions, an other part of the electrical connection portions are negative-electrode electrical connection portions, each of the positive-electrode electrical connection portions is respectively connected to at least one of the plurality of positive-electrode fingers, each of the negative-electrode electrical connection portions is respectively connected to at least one of the plurality of negative-electrode fingers, at least one of the plurality of negative-electrode fingers is partially provided with at least one negative-electrode insulation portion, at least one of the plurality of positive-electrode fingers is partially provided with at least one positive-electrode insulation portion, orthographic projections of the positive-electrode electrical connection portions and orthographic projections of a plurality of negative-electrode insulation portions in the first direction coincide, and orthographic projections of the negative-electrode electrical connection portions and orthographic projections of a plurality of positive-electrode insulation portions in the first direction coincide.

In a second aspect, some embodiments of the present invention disclose a photovoltaic module, including a plurality of conductive wires and a plurality of solar cells, where the plurality of solar cells are electrically connected to each other by the plurality of conductive wires, at least one of the plurality of solar cells is the solar cell in the first aspect, and at least one of the plurality of conductive wires extends in the first direction and is connected to the plurality of edge electrical connection portions and the plurality of middle electrical connection portions.

In some possible implementations of the second aspect, the photovoltaic module satisfies at least one of the following:
a width of each of the plurality of conductive wires in the second direction is D5, a size of each of the plurality of electrical connection portions in the second direction is D4, and the second direction is perpendicular to the first direction, where D4>D5; and
each of the plurality of conductive wires is a solder strip.

In a third aspect, some embodiments of the present invention disclose a printing screen for printing an electrical connection material on the solar cell in the first aspect, where the printing screen includes a printing surface, the printing surface is provided with a plurality of printing holes, the plurality of printing holes include a plurality of printing holes spaced apart in a column along a third direction, and the printing surface includes a screen middle region and screen edge regions disposed at opposite ends of the screen middle region in the third direction; among the plurality of printing holes in the column, a part of the plurality of printing holes in the column are edge printing holes and an other part of the plurality of printing holes in the column are middle printing holes, the edge printing holes are disposed in the screen edge regions, a maximum size of at least one of the edge printing holes in the third direction is D6, the middle printing holes are disposed in the screen middle region, and a maximum size of at least one of the middle printing holes in the third direction is D7, wherein D6>D7.

In some possible implementations of the third aspect, among the plurality of printing holes in the column, there are a plurality of edge printing holes, the plurality of edge printing holes include a first edge printing hole and at least one second edge printing hole, the first edge printing hole is an edge printing hole among the plurality of edge printing holes that is farthest away from the screen middle region, a maximum size of the first edge printing hole in the third direction is D61, and a maximum size of a second edge printing hole in the third direction is D62, where D61>D62.

Compared with the art known to inventors, the present invention has beneficial effects as follows:
the solar cell is provided with the edge electrical connection portions having greater sizes, and bonding structures of the conductive wires used during an electrical connection of the solar cell and the edge electrical connection portions have greater sizes, so that the bonding strength between the edge electrical connection portions and the conductive wires is higher, which is beneficial to reducing the phenomenon of the edge electrical connection portions disengaging from the conductive wires, so as to improve the thermal cycle reliability and current transmission performance of the solar cell, thereby improving the thermal cycle reliability and power of the photovoltaic module applying the solar cell.

For the solar cell, the plurality of electrical connection portions include the plurality of middle electrical connection portions disposed in the middle region and the plurality of edge electrical connection portions disposed in the edge regions. Each edge electrical connection portion is respectively connected with at least one edge finger, so as to gather current collected by the edge finger. Each middle electrical connection portion is respectively connected with at least one middle finger, so as to gather current collected by the middle finger. Both the middle electrical connection portion and the edge electrical connection portion need to be bonded with the conductive wires to achieve electrical connections, so as to transmit the collected current to the conductive wires.

Under the consideration of different thermal expansion coefficients of the conductive wire and the cell body, the conductive wire and the solar cell are bonded in a heating environment and then are cooled, the conductive wire and the cell body have different thermal expansion and contraction degrees, and the bonding position of the cell body and the conductive wire is easily disengaged when subjected to a greater thermal stress, and in particular, the edge electrical connection portion is subjected to a greater thermal stress, and thus it is easier to disengage from the conductive wire. On this basis, the maximum size of at least one edge electrical connection portion in the first direction is D1. The maximum size of at least one middle electrical connection portion in the first direction is D2, and D1>D2. The conductive wire is disposed along the first direction when the conductive wire is electrically connected with the solar cell, and the maximum size D1 of the edge electrical connection portion in the first direction is greater. In this way, the size of the bonding structure between the edge electrical connection portion and the conductive wire is also greater, and the bonding strength between the edge electrical connection portion and the conductive wire is higher, thereby reducing the phenomenon of the edge electrical connection portion disengaging from the conductive wire, facilitating an improvement in the thermal cycle reliability of the photovoltaic module applying the solar cell, and further facilitating an improvement in the current transmission performance of the solar cell, thus improving the power of the photovoltaic module applying the solar cell.

Although the maximum size D2 of the middle electrical connection portion in the first direction is smaller, the bonding structure on the middle electrical connection portion is subjected to a relatively small thermal stress, the phenomenon of the middle electrical connection portion disengaging from the conductive wire is also fewer, and the middle electrical connection portion also has a smaller light shielding area and lower paste consumption due to the smaller size, which is beneficial to reducing the cost and improving the effect of the solar cell.

### Brief Description of the Drawings

In order to more clearly illustrate technical solutions in the embodiments of the present invention, drawings to be used in the embodiments will be simply introduced below. Apparently, the drawings in the following description are merely some embodiments of the present invention. For those ordinary skilled in the art, other drawings may be obtained according to these drawings without creative efforts.
Fig. 1 is a schematic structural diagram of a solar cell disclosed in an embodiment of the present invention;
Fig. 2 is a partial enlarged view of a region I shown in Fig. 1;
Fig. 3 is a schematic diagram of a connection between a solar cell and conductive wires disclosed in an embodiment of the present invention;
Fig. 4 is a schematic structural diagram of a solar cell (electrical connection portions are provided with hollow portions) disclosed in an embodiment of the present invention;
Fig. 5 is a schematic structural diagram of a solar cell (some edges of electrical connection portions are concave-convex edges) disclosed in an embodiment of the present invention;
Fig. 6 is a schematic structural diagram disclosed in an embodiment of the present invention in a case where a finger is of an intermittent structure;
Fig. 7 is a schematic structural diagram disclosed in an embodiment of the present invention in a case where a finger is of a continuous structure;
Fig. 8 is a schematic structural diagram of a back contact solar cell disclosed in an embodiment of the present invention;
Fig. 9 is a sectional view of a back contact solar cell in a region provided with fingers disclosed in an embodiment of the present invention;
Fig. 10 is a sectional view of a back contact solar cell in a region provided with an electrical connection portion disclosed in an embodiment of the present invention;
Fig. 11 is a schematic structural diagram of a photovoltaic module disclosed in an embodiment of the present invention;
Fig. 12 is a partial enlarged view of a region II shown in Fig. 11;
Fig. 13 is a schematic structural diagram of a printing screen disclosed in an embodiment of the present invention; and
Fig. 14 is a partial enlarged view of a region III shown in Fig. 13.

### Description of reference signs:

10, solar cell; 11, cell body; 111, cell surface; 1111, middle region; 1112, edge region; 112, silicon substrate; 113, N-type doped layer; 114, P-type doped layer; 115, functional film; 12, finger; 121, middle finger; 122, edge finger; 123, positive-electrode finger; 124, negative-electrode finger; 125, sub-finger; 13, electrical connection portion; 131, edge electrical connection portion; 1311, first edge electrical connection; 1312, second edge electrical connection; 132, middle electrical connection portion; 133, hollow portion; 134, concave-convex edge; 135, negative-electrode electrical connection portion; 136, positive-electrode electrical connection portion; 14, negative-electrode insulation portion; 15. positive-electrode insulation portion; Y 1, first direction; X1, second direction; 20, conductive wire; 30, printing screen; 31, printing surface; 311, screen middle region; 312, screen edge region; 32, printing hole; 321, edge printing hole; 3211, first edge printing hole; 3212, second edge printing hole; 322, middle printing hole; Y2, third direction; and X2, fourth direction.

### Detailed Description of the Embodiments

A clear and complete description of technical solutions in the embodiments of the present invention will be given below, in combination with the drawings in the embodiments of the present invention. Apparently, the embodiments described below are merely a part, but not all, of the embodiments of the present invention. All of other embodiments, obtained by those of ordinary skill in the art based on the embodiments in the present invention without any creative effort, fall into the protection scope of the present invention.

In the present invention, the terms "disposed", "provided with", "connection" and "connected" should be understood in a broad sense. For example, the connection may be a fixed connection, a detachable connection or an integral construction; may be a mechanical connection or an electrical connection; and may be a direct connection, or an indirect connection through an intermediate medium, and may also be internal communication between two devices, elements or components. For those of ordinary skill in the art, the specific meanings of the above terms in the present invention may be understood according to specific situations.

In addition, the terms "first", "second" and the like are mainly used to distinguish different devices, elements or components (specific types and configurations may be the same or different), and are not used to indicate or imply relative importance and the number of the indicated devices, elements or components. Unless otherwise specified, "a plurality of" means two or more.

During the process of manufacturing solar cells into a photovoltaic module, electrical connection portions on the solar cells need to be alloyed with conductive wires, so that the conductive wires are connected to the solar cells, therefore the solar cells are electrically connected by the conductive wires.

It is taken as an example that the conductive wire is a solder strip and the electrical connection portion is a bonding pad, the soldering process is as follows: the solder strip is placed on a solar cell, then the solar cell and the solder strip are heated together to a soldering processing temperature, the solder strip and the bonding pad are soldered to form a solder joint, and the solar cell and the solder strip are cooled together to the room temperature after being soldered. It can be understood that, since the solder strip and the solar cell have different thermal expansion coefficients, the solar cell and the solder strip have different shrinkage degrees after being cooled, the solder strip tends to shrink more than the solar cell, the solder strip applies thermal stress to the solar cell through the solder joint, and in a case where the thermal stress exceeds the bonding strength of the solder joint, a solder joint detachment occurs. The term "solder joint detachment" refers to a phenomenon of the solder joint loosening, disconnecting or disengaging after being soldered, resulting in a failure of an electrical or mechanical connection between the solder strip and the bonding pad that would otherwise be connected by soldering. In particular, for solder joints disposed at the edge of the solar cell, these edge solder joints are more prone to detachment, thereby affecting the thermal cycle reliability and power of the photovoltaic module applying the solar cell.

The reason why the edge solder joints are more prone to detachment is that the sizes of the bonding pads at various positions of the solar cell are generally the same, and the sizes of the solder joints formed after the bonding pads are soldered are also substantially the same. In a case where the sizes of the edge solder joints and the middle solder joints are approximately the same, the bonding strengths between the edge solder joints and the middle solder joints are also approximately the same. However, compared with the middle solder joints, the edge solder joints are subjected to greater thermal stresses, such that the edge solder joints are more prone to the problem of detachment.

It should be noted that even if the electrical connection portions and the conductive wires are bonded in a non-soldering manner, similar problems may also occur. As long as the electrical connection portions and the conductive wires are bonded in a heating environment, the thermal stress may be generated after cooling, and the thermal stresses on bonding structures disposed on the edge electrical connection portions are also greater. In this way, the electrical connection portions disposed at the edges of the solar cell are easier to disengage from the conductive wires.

Based on the above analysis, an embodiment of the present invention provides a solar cell. By providing edge electrical connection portions having greater sizes, bonding structures of the conductive wires used during an electrical connection of the solar cell and the edge electrical connection portions have greater sizes, so that the bonding strength between the edge electrical connection portions and the conductive wires is higher, which is beneficial to reducing the phenomenon of the edge electrical connection portions disengaging from the conductive wires, thereby improving the thermal cycle reliability and power of a photovoltaic module applying the solar cell.

The technical solutions of the present invention are described below in combination with embodiments and the drawings.

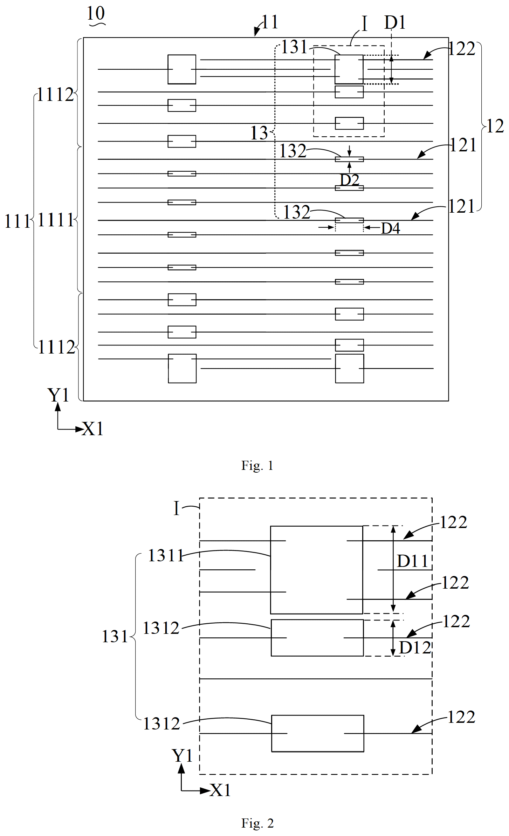

In a first aspect, as shown in Fig. 1, embodiments of the present invention disclose a solar cell 10, including a cell body 11, a plurality of fingers 12 and a plurality of electrical connections 13.

The cell body 11 has a cell surface 111, and the cell surface 111 includes a middle region 1111 and edge regions 1112 disposed at opposite ends of the middle region 1111 in a first direction Y1.

The plurality of fingers 12 are spaced apart on the cell surface 111, and the first direction Y1 is a direction in which the plurality of fingers 12 are disposed at intervals. The plurality of fingers 12 include a plurality of middle fingers 121 disposed in the middle region 1111 and a plurality of edge fingers 122 disposed in the edge regions 1112.

The plurality of electrical connection portions 13 include a plurality of edge electrical connection portions 131 disposed in the edge regions 1112 and a plurality of middle electrical connection portions 132 disposed in the middle region 1111, where each edge electrical connection portion 131 is respectively connected to at least one edge finger 122, and a maximum size of at least one edge electrical connection portion 131 in the first direction Y1 is D1. Each middle electrical connection portion 132 is respectively connected to at least one middle finger 121, a maximum size of at least one middle electrical connection portion 132 in the first direction Y1 is D2, and D1>D2.

The beneficial effects of the solar cell in the present invention are described in detail below.

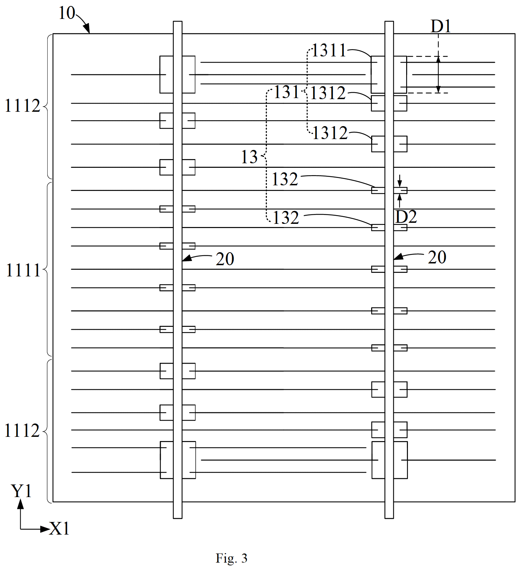

Referring to Fig. 1 and Fig. 3, the solar cell 10 is provided with the edge electrical connection portions 131, each of which has greater sizes, and each bonding structure of the conductive wires 20 used during an electrical connection of the solar cells 10 and the edge electrical connection portions 131 has a greater size, so that the bonding strength between the edge electrical connection portions 131 and the conductive wires 20 is higher, which is beneficial to reducing the phenomenon of the edge electrical connection portions 131 disengaging from the conductive wires 20, so as to improve the thermal cycle reliability and current transmission performance of the solar cell 10, thereby improving the thermal cycle reliability and power of the photovoltaic module applying the solar cell 10. The thermal cycle reliability is measured by a test standard of the following standard number: IEC 61215. Specific analysis is as follows:
on the solar cell 10, the plurality of electrical connection portions 13 include the plurality of middle electrical connection portions 132 disposed in the middle region 111 and the plurality of edge electrical connection portions 131 disposed in the edge regions 1112. In some embodiments, the size of an edge region 1112 in the first direction Y1 is 1%-2% of the size of the cell surface 111 in the first direction.

Each edge electrical connection portion 131 is respectively connected to at least one edge finger 122, so as to gather current collected by the edge finger 122. Each middle electrical connection portion 132 is respectively connected to at least one middle finger 121, so as to gather current collected by the middle finger 121. Both the middle electrical connection portion 132 and the edge electrical connection portion 131 need to be bonded with the conductive wire 20 to achieve electrical connections, so as to transmit the collected current to the conductive wire 20.

Under the consideration of different thermal expansion coefficients of the conductive wires 20 and the cell body 11, the conductive wires 20 and the solar cell 10 are bonded in a heating environment and then are cooled, the conductive wires 20 and the cell body 11 have different thermal expansion and contraction degrees, and the bonding positions of the cell body 11 and the conductive wires 20 is easily disengaged when subjected to a greater thermal stress, and in particular, the edge electrical connection portion 131 is subjected to a greater thermal stress, and thus it is easier to disengage from the conductive wire 20. On this basis, the maximum size of at least one edge electrical connection portion 131 in the first direction Y1 is D1. The maximum size of at least one middle electrical connection portion 132 in the first direction Y1 is D2, and D1>D2. The conductive wire 20 is disposed in the first direction Y1 when the conductive wire 20 is electrically connected to the solar cell 10, and the maximum size D1 of the edge electrical connection portion 131 in the first direction Y1 is greater. In this way, the size of the bonding structure between the edge electrical connection portion 131 and the conductive wire 20 is also greater, and the bonding strength between the edge electrical connection portion 131 and the conductive wire 20 is higher, thereby reducing the phenomenon of the edge electrical connection portion 131 disengaging from the conductive wire 20, facilitating an improvement in the thermal cycle reliability of the photovoltaic module applying the solar cell 10, and further facilitating an improvement in the current transmission performance of the solar cell 10, thus improving the power of the photovoltaic module applying the solar cell 10.

Although the maximum size D2 of the middle electrical connection portion 132 in the first direction Y1 is smaller, the bonding structure on the middle electrical connection portion 132 is subjected to a relatively small thermal stress, the phenomenon of the middle electrical connection portion 132 disengaging from the conductive wire 20 is also fewer, and the middle electrical connection portion 132 also has a smaller light shielding area and lower paste consumption due to the smaller size, which is beneficial to reducing the cost and improving the effect of the solar cell 10.

In the present invention, the paste refers to raw materials for printing the fingers 12 and the electrical connection portions 13, for example, it is silver paste, aluminum paste, silver-aluminum paste, copper paste or silver-coated copper paste, which is not limited in the embodiments of the present invention.

It should be noted that the maximum size D1 of the edge electrical connection portion 131 in the first direction Y1 does not mean that the size of the edge electrical connection portion 131 in the first direction Y1 must have a plurality of values to ensure the presence of the maximum value. In a case where the edge electrical connection portion 131 has only one size in the first direction Y1, for example, for an edge electrical connection portion 131 in a square shape, the maximum size D1 of the edge electrical connection portion 131 in the first direction Y1 refers to the size of the edge electrical connection portion 131 in the first direction Y1. In a case where the edge electrical connection portion 131 has a plurality of sizes in the first direction Y1, for example, in a case where edges of the edge electrical connection portion 131 in the first direction Y1 is uneven, the maximum size D1 of the edge electrical connection portion 131 in the first direction Y1 refers to a maximum size among a plurality of sizes of the edge electrical connection portion 131 in the first direction Y1. Similarly, the actual meaning of the maximum size D2 of the middle electrical connection portion 132 in the first direction Y 1 may be understood in combination with the above explanations, and thus details are not repeated herein again.

The edge electrical connection portions and the edge fingers in the present invention are described in detail below.

With reference to Fig. 1 and Fig. 2, in order to gather the current of the plurality of edge fingers 122 spaced apart in the first direction Y1, in some embodiments, a plurality of edge electrical connection portions 131 are disposed in at least one edge region 1112, and a plurality of edge electrical connection portions 131 include a plurality of edge electrical connection portions 131 spaced apart in a column in the first direction Y1. Since each edge electrical connection portion 131 is respectively connected to at least one edge finger 122, the edge electrical connection portions 131 in the same column may gather the current of the plurality of edge fingers 122 spaced apart in the first direction Y1.

It should be noted that, referring to Fig. 3, among the edge electrical connection portions 131 in the same column, after the edge electrical connection portions 131 at different positions are bonded with the conductive wires 20, the bonding structures they formed are subjected to different thermal stresses. Specifically, the bonding structures farther away from the middle region 1111 are subjected to greater thermal stresses, and thus are easier to disengage from the conductive wires 20.

Based on the above analysis, referring to Fig. 1 and Fig. 2, in the present embodiment, among the edge electrical connection portions 131 in the same column, a part of the edge electrical connection portions 131 are first edge electrical connection portions 1311 and the other part of the edge electrical connection portions 131 are second edge electrical connection portions 1312, the second edge electrical connection portions 1312 are closer to the middle region 1111 than the first edge electrical connection portions 1311, a maximum size of the first edge electrical connection portion 1311 in the first direction Y1 is D11, and a maximum size of the second edge electrical connection portion 1312 in the first direction Y1 is D12, and D11>D12.

It can be understood that, with reference to Fig. 3, compared with the second edge electrical connection portion 1312, the first edge electrical connection portion 1311 is farther away from the middle region 1111, and the bonding structure on the first edge electrical connection portion 1311 is subjected to a greater thermal stress, so the first edge electrical connection portion 1311 is easier to disengage from the conductive wire 20. On this basis, a maximum size D11 of the first edge electrical connection 1311 in the first direction Y1 is greater than a maximum size D12 of the second edge electrical connection 1312 in the first direction Y1. Correspondingly, the bonding structure of the conductive wire 20 disposed along the first direction Y1 and each of the first edge electrical connection portions 1311 has a greater size, so that the bonding strength between the first edge electrical connection portion 1311 and the conductive wire 20 is higher, which is beneficial to reducing the phenomenon of the first edge electrical connection portion 1311 disengaging from the conductive wire 20.

With reference to Fig. 1 to Fig. 3, in a direction from the edge region 1112 to the middle region 1111, among electrical connection portions 13 in the same column and connected to the same conductive wire 20, the first to third electrical connection portions 13 are subjected to greater thermal stresses and thus have greater risks of disengaging from the conductive wire 20. Moreover, the first electrical connection portion 13 is subjected to the greatest thermal stress, and thus has the maximum risk of disengaging from the conductive wire 20. On this basis, in the embodiments of the present invention, in the same edge region 1112, the first edge electrical connection portion 1311 is an edge electrical connection portion 131 farthest away from the middle region 1111. In the same edge region 1112, there are two second edge electrical connection portions 131.

It can be understood that the first edge electrical connection portion 1311 is the first electrical connection portion 13, two second edge electrical connection portions 1312 are the second and third electrical connection portions 13, the first edge electrical connection portion 1311 and the two second edge electrical connection portions 1312 all have greater sizes than each of the middle electrical connection portions 132, thereby effectively reducing the risk of the conductive wire 20 disengaging from the edge electrical connection portion 131. Moreover, the first edge electrical connection portion 1311 is also the electrical connection portion having the maximum size among the electrical connection portions 13 in the same column and connected to the same conductive wire 20, so that the first edge electrical connection portion 1311 can resist against a greater thermal stress, thereby reducing the risk of the first edge electrical connection portion 1311 disengaging from the conductive wire 20.

In some embodiments, one, three, four or other numbers of second edge electrical connections may also be disposed, which is not limited in the embodiments of the present invention.

In some embodiments, as shown in Fig. 2, the maximum size D11 of the first edge electrical connection portion 1311 in the first direction Y1 ranges from 0.5mm to 2mm, for example, it may be 0.5mm, 1mm, 1.5mm or 2mm. In a case where the maximum size D11 of the first edge electrical connection portion 1311 in the first direction Y1 satisfies the above size range, the size of the bonding structure on the first edge electrical connection portion 1311 is large enough, so that the bonding strength between the first edge electrical connection portion 1311 and the conductive wire 20 is higher, so as to effectively reduce the disengagement phenomenon. Moreover, the maximum size D11 of the first edge electrical connection portion 1311 in the first direction Y1 is not too large, thereby having a smaller light shielding area and further having lower paste consumption during printing.

In some embodiments, as shown in Fig. 2, the maximum size D12 of the second edge electrical connection portion 1312 in the first direction Y1 ranges from 0.2mm to 0.5mm, for example, it may be 0.2mm, 0.3mm, 0.4mm or 0.5mm. In a case where the maximum size D12 of the second edge electrical connection portion 1312 in the first direction Y1 satisfies the above size range, the size of the bonding structure on the second edge electrical connection portion 1312 is large enough, so that the bonding strength between the second edge electrical connection portion 1312 and the conductive wire 20 is higher, so as to effectively reduce the disengagement phenomenon. Moreover, the maximum size D12 of the second edge electrical connection portion 1312 in the first direction Y1 is not too large, thereby having a smaller light-shielding area and further having lower paste consumption during printing.

Referring to Fig. 2, under the consideration that the size of the first edge electrical connection portion 1311 in the first direction Y1 is greater, in order to improve the current collection efficiency of the first edge electrical connection portion 1311, in the present embodiment, some of the plurality of edge fingers 122 spaced apart in the first direction Y1 are connected to the first edge electrical connection portion 1311. That is, each of the first edge electrical connection portions 1311 is connected to a plurality of edge fingers 122. In this way, the first edge electrical connection portion 1311 can gather the current of the plurality of edge fingers 122, which is beneficial to improving the current collection efficiency.

In some embodiments, the number of the edge finger connected to a first edge electrical connection portion may be one. Similarly, one or more edge fingers may be connected to a second edge electrical connection portion.

The middle electrical connection portions and the middle fingers in the present invention are described in detail below.

In some embodiments, referring to Fig. 1, a plurality of middle fingers 121 are disposed, a plurality of middle electrical connection portions 132 are disposed, the middle electrical connection portions 132 are respectively connected to the middle fingers 121 in a one-to-one manner, each of the middle electrical connection portions 132 has the same size, and each of the middle electrical connection portions 132 has the same pattern, thereby facilitating efficient and accurate identification of a visual inspection system, and facilitating the monitoring of the manufacturing quality of the middle electrical connection portions 132 in a production process.

For example, two, three, four or five middle fingers 121 may be disposed, and correspondingly, two, three, four or five middle electrical connection portions 132 may be disposed. In some embodiments, other numbers of middle fingers 121 and middle electrical connection portions 132 may also be disposed. A single middle electrical connection portion 132 may also be connected to a plurality of middle fingers 121, which is not limited in the embodiments of the present invention.

In some embodiments, the size D2 of each middle electrical connection portion 132 in the first direction Y1 ranges from 0.1mm to 0.3mm, for example, it may be 0.1mm, 0.2mm or 0.3mm. In a case where the size D2 of the middle electrical connection portion 132 in the first direction Y1 satisfies the above size range, the middle electrical connection portion 132 can not only form good bonding with the conductive wire 20, but also have a smaller light shielding area and lower paste consumption.

The electrical connection portions are described in detail below.

In some embodiments, referring to Fig. 1, each of the electrical connection portions 13 has the same size D4 in a second direction X1, and the second direction X1 is perpendicular to the first direction Y1. Such a design enables the sizes of images of the electrical connection portions 13 to be unified in one direction, thereby facilitating the efficient and accurate identification of the visual inspection system, and facilitating the monitoring of the manufacturing quality of the electrical connection portions 13 in the production process.

In some embodiments, the size D4 of each electrical connection portion 13 in the second direction X1 ranges from 0.5mm to 3mm, for example, it may be 0.5mm, 1mm, 2mm or 3mm. In a case where the size D4 of each electrical connection portion 13 in the second direction X1 satisfies the above size range, each electrical connection portion 13 can not only form good bonding with the conductive wire 20, but also have a smaller light shielding area and lower paste consumption.

In some embodiments, each electrical connection portion 13 is a bonding pad, and each conductive wire 20 is a solder strip. Correspondingly, the bonding structure refers to a solder joint between the bonding pad and the solder strip.

It should be noted that in the art, the bonding pad is also referred to as a PAD point or a reinforcement point. In a case where the electrical connection portion 13 is a bonding pad, the edge electrical connection portion 131 is an edge bonding pad, and the middle electrical connection portion 132 is a middle bonding pad.

It can be understood that, when the bonding pad is soldered with the solder strip, the temperature of soldering processing is often relatively high, which tends to be 200° C or more. After cooling to the room temperature, the solder joint between the bonding pad and the solder strip is subjected to a greater thermal stress. According to the above analysis, the solder joint on the edge bonding pad is subjected to a greater thermal stress and thus has a higher desoldering risk. In the present invention, a maximum size of the edge bonding pad in the first direction Y1 is disposed to be greater than a maximum size of the middle bonding pad in the first direction Y1, so that the size of the solder joint on the edge electrical connection portion 131 is greater, thereby reducing the phenomenon of detachment in the edge region.

In the present invention, on the premise of reducing the influence on the thermal cycle reliability, in order to reduce the paste consumption during the printing of the electrical connection portion and reduce the light shielding area of the electrical connection portion, the electrical connection portion may be provided with at least one hollow portion, or at least one edge of the electrical connection portion is a concave-convex edge, or the electrical connection portion is provided with at least one hollow portion, and meanwhile at least one edge of the electrical connection portion is a concave-convex edge.

The hollow portion of the electrical connection portion in the present invention is described in detail below.

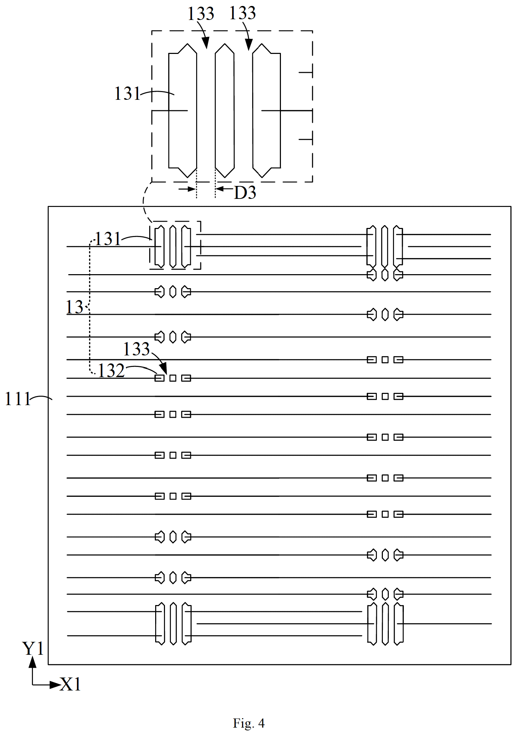

In some embodiments, referring to Fig. 4, at least one electrical connection portion 13 is provided with hollow portions 133, and the cell surface 111 is exposed to setting regions of the hollow portions 133.

It can be understood that, no paste is printed in each setting region of the hollow portion 133, thereby saving paste to reduce the production cost of the solar cell 10. Since the cell surface 111 is exposed to the setting region of the hollow portion 133, the hollow portion 133 further has the effect of reducing the light shielding area of the electrical connection portion 13, thereby facilitating an improvement in the conversion efficiency of the solar cell 10.

In some embodiments, the hollow portion 133 penetrates through the electrical connection portion 13 in the first direction Y1. In that case, the hollow portion 133 is equivalent to a fracture formed on the electrical connection portion 13, the fracture disconnects the electrical connection portion 13 to form a plurality of electrical connection sub-portions, the maximum size of each of the electrical connection portion 13 in the first direction Y1 is not reduced by disposing the fracture, and thus the electrical connection portion 13 can still form a bonding structure having a greater size with the conductive wire 20.

In some embodiments, one or more hollow portions 133 are disposed on the same electrical connection portion 13, in a case where a plurality of hollow portions 133 are disposed on the same electrical connection portion 13, the plurality of hollow portions 133 are spaced apart in the second direction X1, and the second direction X1 intersects with the first direction Y1.

It can be understood that, in a case where the size D3 of the hollow portion 133 in the second direction X1 is less than 0.1mm, the size of the hollow portion 133 is too small, and thus the light shielding area and the paste consumption of the electrical connection portion 13 are not obviously reduced. In a case where the size D3 of the hollow portion 133 in the second direction X1 is greater than 0.5mm, since it is necessary to print an electrical connection material, for example, solder paste, on the electrical connection portion 13 before the electrical connection portion 13 is bonded with the conductive wire 20, in a case where the size of the hollow portion 133 is too large, the electrical connection material is more prone to printing offset or excessive aggregation, resulting in disconnection of the electrical connection portion 13 from the conductive wire 20. In some embodiments, the size D3 of the hollow portion 133 in the second direction X1 ranges from 0.1mm to 0.5mm, for example, it is 0.1mm, 0.3mm or 0.5mm. In a case where the size D3 of the hollow portion 133 in the second direction X1 satisfies the above size range, the light shielding area and the paste consumption of the electrical connection portion 13 can be effectively reduced, and the electrical connection material can be better printed on the electrical connection portion 13 to reduce the risk of disconnection of the electrical connection portion 13.

If there is only one hollow portion 133 on one electrical connection portion 13, since the size D3 of the hollow portion 133 in the second direction X1 needs to satisfy the above size range, the reduction in the light shielding area and the paste consumption of the electrical connection portion 13 by one hollow portion 133 is limited. If there are five hollow portions 133 on one electrical connection portion 13, the area of non-hollow regions of the electrical connection portion 13 is too small, and thus a contact area between the electrical connection portion 13 and the conductive wire 20 is too small, thereby affecting the bonding between the electrical connection portion 13 and the conductive wire 20. In some embodiments, one electrical connection portion 13 is provided with 2 to 5 hollow portions 133. In this way, the reduce the light shielding area and the paste consumption by disposing a plurality of hollow portions 133 on the electrical connection portion 13, and the size D3 of each hollow portion 133 in the second direction X1 satisfies the above size range, so that the area of the non-hollow region of the electrical connection portion 13 is large enough, therefore the contact area between the electrical connection portion 13 and the conductive wire 20 is greater, and thus the electrical connection portion 13 and the conductive wire 20 can form good bonding.

It is considered that when the size of the edge electrical connection portion 131 is increased, both the light shielding area and the paste consumption of the edge electrical connection portion 131 are greater. On this basis, in the embodiments of the present invention, the hollow portion 133 is disposed on the edge electrical connection portion 131, thereby alleviating the influence caused by an increase in the size of the edge electrical connection portion 131, so that the edge electrical connection portion 131 can have a lower light shielding area and lower paste consumption.

In some embodiments, the hollow portion 133 may also be disposed on the middle electrical connection portion 132.

The concave-convex edge of the electrical connection portion in the present invention is described in detail below.

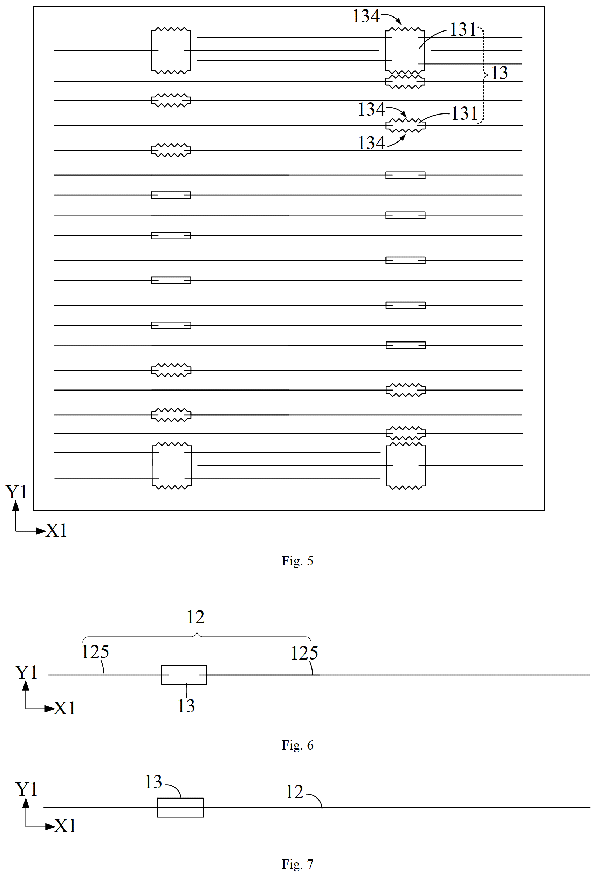

In some embodiments, referring to Fig. 5, at least one of the edges of at least one electrical connection portion 13 is a concave-convex edge 134.

The term "concave-convex edge 134" refers to an uneven edge, and the concave-convex edge 134 may cause a change in the size of the electrical connection portion 13 in a corresponding direction along the edge. For example, in a case where edges of the electrical connection portion 13 in the first direction Y1 are concave-convex edges 134, the size of the electrical connection portion 13 in the first direction Y1 is greater at protruding positions of the edges. On the contrary, the size of the electrical connection portion 13 in the first direction Y1 is smaller at a sunken position on the edges. Similarly, in a case where edges of the electrical connection portion in the second direction are concave-convex edges, the size of the electrical connection portion in the second direction also changes according to the concave-convex edges, which will not be repeated herein again.

It can be understood that the concave-convex edge 134 enables to reduce the size of the electrical connection portion 13 by means of the sunken position on the edge of the electrical connection portion 13, which is beneficial to reducing the light shielding area of the electrical connection portion 13 and the paste consumption during printing. The electrical connection portion 13 has the maximum size at the protruding position of the edge, so that the size of the bonding structure between the electrical connection portion 13 and the conductive wire is large enough to reduce the disengagement phenomenon.

Considering that the maximum size of the edge electrical connection portion 131 in the first direction Y1 is greater than the maximum size of the middle electrical connection portion 132, it is more urgent to reduce the light shielding area and the paste consumption of the edge electrical connection portion 131. On this basis, in the present invention, at least one edge electrical connection portion 131 includes, in the first direction Y1, at least one edge that is a concave-convex edge 134.

In some embodiments, the concave-convex edge may also be disposed at an edge of at least one edge electrical connection portion in the second direction. The edge of the middle electrical connection portion in at least one of the first direction and the second direction may also be a concave-convex edge.

Exemplarily, the concave-convex edge 134 is sawtooth-shaped. The term "sawtooth-shaped" is a shape description, which means that the edge of an object exhibits the same form as serrations, and has a series of protruding projections and sunken portions with regular intervals, and has a shape similar to serration. As other examples, the concave-convex edge may also be curve-shaped. The term "curve-shaped" is a shape description, which means that the edge of the object exhibits the form of a curve, for example, a wavy-line shape.

It should be noted that, in order to reduce the paste consumption during the printing of the electrical connection portion and reduce the light shielding area of the electrical connection portion, the electrical connection portion may be provided with the concave-convex edge and the hollow portion at the same time. In some embodiments, the electrical connection portion may also be only provided with the concave-convex edge or the hollow portion.

The finger in the present invention will be described in detail below.

In some embodiments, referring to Fig. 6 and Fig. 7, the finger 12 is of an intermittent structure or a continuous structure.

As shown in Fig. 6, in a case where the finger 12 is of the intermittent structure, the finger 12 includes a plurality of sub-fingers 125 spaced apart in the second direction X1, each sub-finger 125 extends in the second direction X1, and the ends of two adjacent sub-fingers 125 close to each other are connected to the same electrical connection portion 13.

Since the pattern of a printing hole for printing a finger on a printing screen is the same as the pattern of the finger 12, the printing hole for printing the finger on the printing screen is of an intermittent structure, and the printing hole for printing the finger is disconnected to form a plurality of printing sub-holes, each of which has a smaller length, for printing the finger . Since the printing sub-holes are formed by removing the material on the printing screen, the finger sub-holes are equivalent to weak regions on the printing screen, the length of the finger printing sub-hole is smaller, that is, the weak region on the printing screen are shorter, so that the structural strength of the printing screen is stronger, the service life is longer, and particularly for a high-aperture-rate printing screen having an aperture ratio of 90% to 100%.

On the other hand, in a case where the finger 12 is stacked on the electrical connection portion 13, the finger 12 forms protrusions on the surface of the electrical connection portion 13, and the greater the area of the protrusion has, the more uneven the surface of the electrical connection portion 13 is. On this basis, in a case where the finger 12 is of the intermittent structure, only the end portions of the sub-finger 125 are stacked on the electrical connection portion 13. In this way, the surface of the electrical connection portion 13 is relatively even, which is beneficial to spreading the electrical connection material on the surface of the electrical connection portion 13. Since the electrical connection material can form good bonding between the electrical connection portion 13 and the conductive wire 20, in a case where the electrical connection material is spread more uniformly on the surface of the electrical connection portion 13, the bonding effect between the electrical connection portion 13 and the conductive wire 20 is better.

As shown in Fig. 7, in a case where the finger 12 is of the continuous structure, the finger 12 extends in the second direction X1 and penetrates through the connected electrical connection portion 13, and the second direction X1 intersects with the first direction Y1.

During printing, the finger 12 of the continuous structure has lower requirements for alignment precision in the second direction X1, the finger 12 may still be lapped on the electrical connection portion 13 even if a printing offset occurs in the second direction X1, thereby improving the lap-joint success rate between the finger 12 and the electrical connection portion 13; and moreover, the current transmission continuity of the finger 12 of the continuous structure is better.

The type of the solar cell is described in detail below.

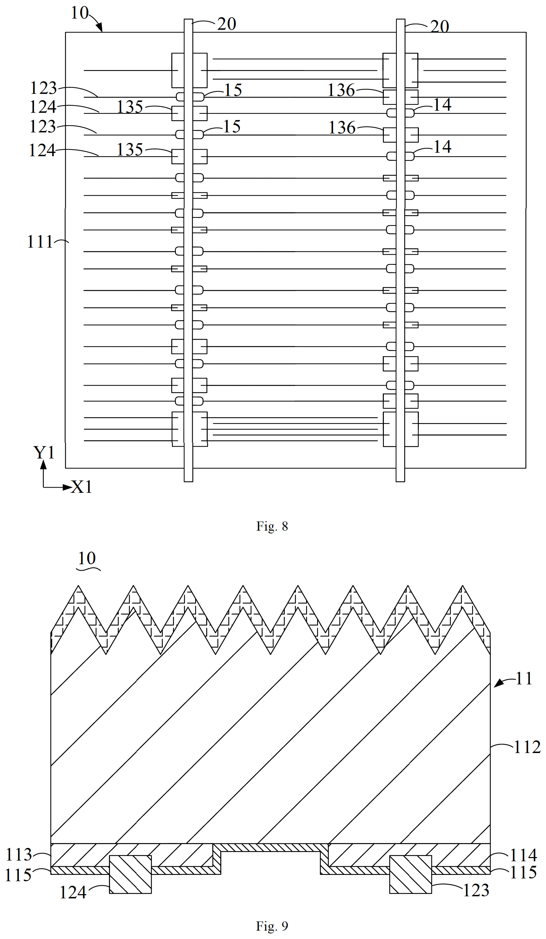

In some embodiments, referring to Fig. 8, the solar cell 10 is a busbar-free solar cell. The busbar-free solar cell is provided with no busbar, so that the light shielding area becomes smaller, which is beneficial to improving the conversion efficiency of the busbar-free solar cell. Moreover, the current collected by the finger 12 is directly conducted to the conductive wire 20 by the electrical connection portion 13 instead of being conducted to the conductive wire 20 by a busbar, so that a current collection path is shorter, thereby improving the power of a photovoltaic module applying the busbar-free solar cell. Since the width of the finger 12 of the busbar-free solar cell is smaller, it is difficult to bond the conductive wire 20 with the finger 12. In the present invention, the electrical connection portion 13 connected to the finger 12 is disposed to assist in connecting the finger 12 and the conductive wire 20.

In some embodiments, the maximum size of the electrical connection portion 13 in the first direction Y1 may be greater than a line width of the finger 12.

In some embodiments, referring to Fig. 8, the solar cell 10 is a back contact solar cell, the cell surface 111 is a backlight surface, a part of the plurality of fingers are positive-electrode fingers 123 and the other part of the fingers are negative-electrode fingers 124, a plurality of positive-electrode fingers 123 and a plurality of negative-electrode fingers 124 are provided, and the positive-electrode finger 123 and the negative-electrode finger 124 are alternately disposed in the first direction Y1. A part of the plurality of electrical connection portions are positive-electrode electrical connection portions 136, the other part of the electrical connection portions are negative-electrode electrical connection portions 135, each positive-electrode electrical connection portion 136 is respectively connected to at least one positive-electrode finger 123, each negative-electrode electrical connection portion 135 is respectively connected to at least one negative-electrode finger 124, at least one negative-electrode finger 124 is partially provided with a negative-electrode insulation portion 14, at least one positive-electrode finger 123 is partially provided with a positive-electrode insulation portion 15, orthographic projections of the plurality of positive-electrode electrical connection portions 136 and orthographic projections of the plurality of negative-electrode insulation portions 14 in the first direction Y1 coincide, and orthographic projections of the plurality of negative-electrode electrical connection portions 135 and orthographic projections of the plurality of positive-electrode insulation portions 15 in the first direction Y1 coincide.

It can be understood that, all the fingers 12 and the electrical connection portions 13 of the back contact solar cell are disposed on the backlight surface of the cell body 11, so that light on the light receiving surface of the cell body 11 is not shielded by grid lines, thereby increasing the absorption area of the light, and thus improving the conversion efficiency of the back contact solar cell. However, the conductive wires 20 are also disposed on the backlight surface of the cell body 11, the bonding structures formed by the conductive wires 20 and the electrical connection portions 13 are disposed on the backlight surface of the cell body 11, and the thermal stresses received by the bonding structures are concentrated on the backlight surface of the cell body 11, such that the cell body 11 is subjected to a greater thermal stress. In a thermal cycle reliability test, the bonding structures disposed in the edge regions are very easy to disengage. On this basis, in a case where the solar cell 10 in the present invention is a back contact solar cell, the solar cell 10 can not only prevent the light on the light receiving surface from being shielded by the grid lines, but also reduce the disengagement phenomenon of the conductive wires 20, thereby having good thermal cycle reliability.

In addition, since the positive-electrode fingers 123 and the negative-electrode fingers 124 are all disposed on the backlight surface, the conductive wires 20 connected to the positive-electrode fingers 123 also span across the negative-electrode fingers 124 in general, which in turn may cause a short circuit phenomenon. Vice versa, the conductive wires 20 connected to the negative-electrode fingers 124 also span across the positive-electrode fingers 123. In order to avoid the above short circuit definition, the back contact solar cell 10 in the present invention is provided with the negative-electrode insulation portions 14 and the positive-electrode insulation portions 15, and the negative-electrode insulation portions 14 separate the negative-electrode fingers 124 from the conductive wires 20 connected to the positive-electrode fingers 123. The positive-electrode insulation portions 15 separate the positive-electrode fingers 123 from the conductive wires 20 connected to the negative-electrode fingers 124.

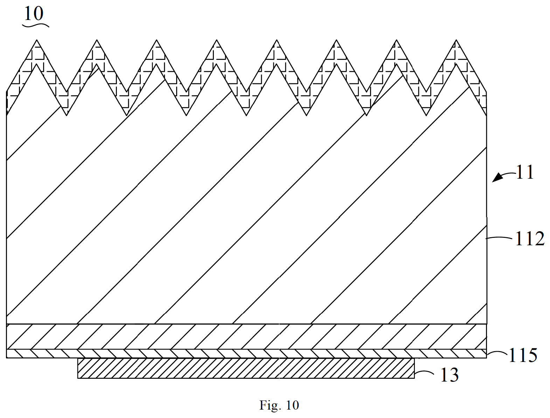

Referring to Fig. 9 and Fig. 10, in a case where the solar cell 10 is a back contact solar cell, the cell body 11 includes a silicon substrate 112, an N-type doped layer 113, a P-type doped layer 114 and a functional film 115, the N-type doped layer 113 and the P-type doped layer 114 are spaced apart on a backlight surface of the silicon substrate 112, and the functional film 115 is at least stacked on the side of the N-type doped layer 113 and the P-type doped layer 114 that away from the silicon substrate 112. The N-type doped layer 113 is, for example, an N-type doped polysilicon layer or an N-type diffusion layer, and the P-type doped layer 114 is, for example, a P-type doped polysilicon layer or a P-type diffusion layer. The functional film 115 is, for example, at least one of a passivation film or an anti-reflection film. Exemplarily, the material of the functional film 115 may be any one or more of silicon nitride, aluminum oxide, silicon oxide or silicon oxynitride.

On this basis, the positive-electrode finger 123 passes through the functional film 115 to form an ohmic contact with the P-type doped layer 114, and the negative-electrode finger 124 passes through the functional film 115 to form an ohmic contact with the N-type doped layer 113. The electrical connection portion 13 has a relatively large size, and the electrical connection portion 13 is printed using non-burnthrough paste, so that the electrical connection portion 13 is disposed on the side, away from the silicon substrate 112, of the functional film 115, that is, the electrical connection portion 13 does not penetrate through the functional film 115, which is beneficial to reducing damage to the functional film 115.

In some embodiments, the solar cell 10 may also be a passivated contact solar cell, a heterojunction solar cell or a stacked solar cell.

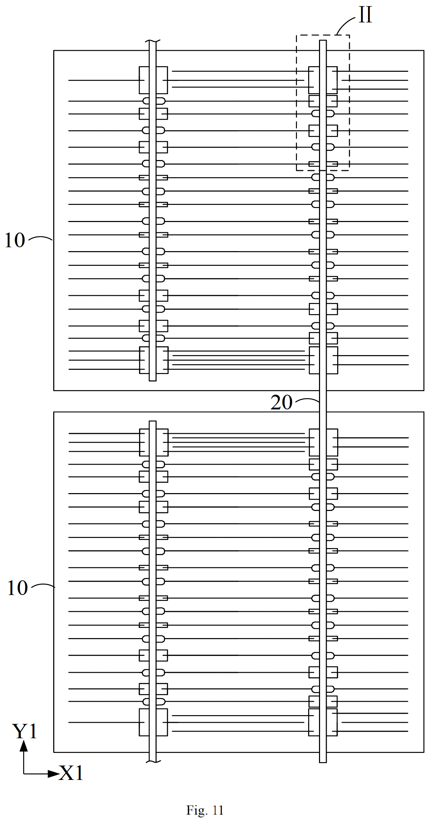

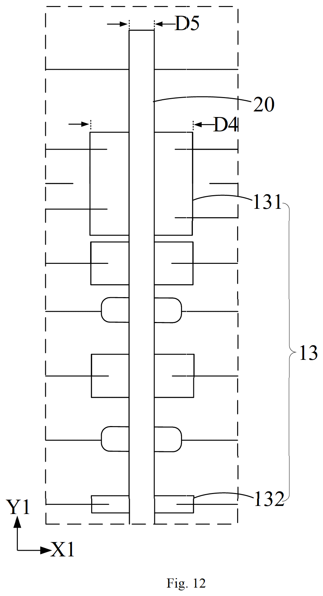

In a second aspect, as shown in Fig. 11 and Fig. 12, embodiments of the present invention disclose a photovoltaic module, including a plurality of conductive wires 20 and a plurality of solar cells 10, where the solar cells 10 are electrically connected to each other by the conductive wires 20, at least one solar cell 10 is the solar cell 10 in the first aspect, and at least one conductive wire 20 extends in the first direction Y1 and is connected to the edge electrical connection portions 131 and the middle electrical connection portions 132.

The electrical connection between the solar cells 10 may be at least one of series connection or parallel connection.

The beneficial effects of the photovoltaic module are described below.

The solar cell 10 of the photovoltaic module is provided with the edge electrical connection portions 131 having greater sizes, and bonding structures of the conductive wires 20 used during an electrical connection of the solar cell 10 and the edge electrical connection portions 131 have greater sizes, so that the bonding strength between the edge electrical connection portions 131 and the conductive wires 20 is higher, which is beneficial to reducing the phenomenon of the edge electrical connection portions 131 disengaging from the conductive wires 20, thereby improving the thermal cycle reliability and power of the photovoltaic module.

In some embodiments, as shown in Fig. 12, the width of the conductive wire 20 in the second direction X1 is D5, the size of the electrical connection portion 13 in the second direction X1 is D4, and the second direction X1 is perpendicular to the first direction Y1, and D4>D5. In this way, even if the conductive wire 20 generates an offset when being placed in the second direction X1, as long as the conductive wire 20 is not removed from the setting region of the electrical connection portion 13 in the second direction X1, the conductive wire 20 may still contact the electrical connection portion 13 so as to be bonded with the electrical connection portion 13, thereby facilitating an improvement in the thermal cycle reliability of the photovoltaic module.

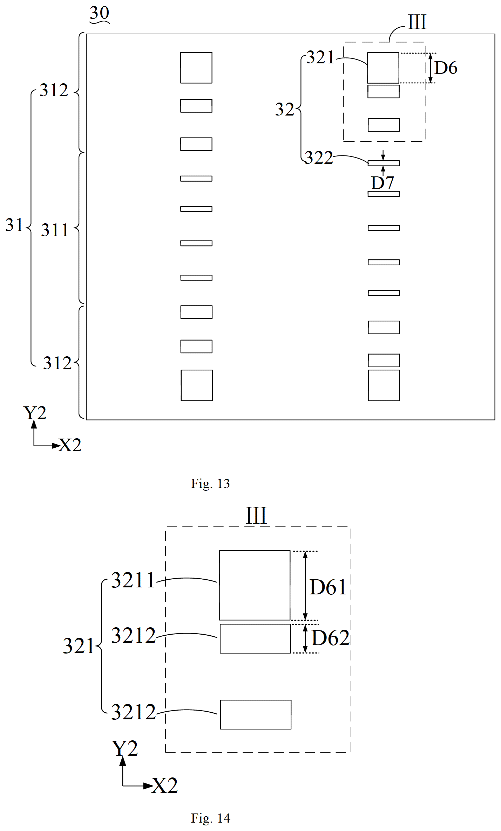

In a third aspect, as shown in Fig. 13 and Fig. 14, embodiments of the present invention disclose a printing screen 30 for printing electrical connection materials on the solar cell in the first aspect. The printing screen 30 includes a printing surface 31, the printing surface 31 is provided with a plurality of printing holes 32, the plurality of printing holes 32 include a plurality of printing holes 32 spaced apart in a column along a third direction, and the printing surface 31 includes a screen middle region 311 and screen edge regions 312 disposed at opposite ends of the screen middle region 311 in the third direction Y1. Among the printing holes 32 in the same column, a part of the printing holes 32 in the same column are edge printing holes 321 and the other part of the printing holes 32 in the same column are middle printing holes 322, the edge printing holes 321 are disposed in the screen edge regions 312, a maximum size of at least one edge printing hole 321 in the third direction Y2 is D6, the middle printing holes 322 are disposed in the screen middle region 311, and a maximum size of at least one middle printing hole 322 in the third direction Y2 is D7, and D6>D7.

It should be noted that the term "printing surface 31" refers to a surface on the printing screen 30 that is perpendicular to a thickness direction of the printing screen 30, for example, a surface on which the printing screen 30 is attached to a solar cell to be printed. It can be understood that the printing hole 32 should penetrate through the thickness direction of the printing screen 30, so that the electrical connection material can penetrate through the printing hole 32 to be printed. The electrical connection material is, for example, solder paste, that is, the printing screen 30 may be a solder paste screen.

The beneficial effects of the printing screen are described below.

In the printing screen 30, the edge printing hole 321 is configured to print the electrical connection material on the edge electrical connection portion, the middle printing hole 322 is configured to print the electrical connection material on the middle electrical connection portion. The electrical connection material facilitates the formation of the bonding structure and the electrical connection between the conductive wire and the electrical connection portion.

Considering that the maximum size of the edge electrical connection portion in the first direction is greater than the maximum size of the middle electrical connection portion in the first direction, in order to match the size of an electrical connection material layer printed by the printing hole 32 with the size of the corresponding electrical connection portion, the maximum size D6 of the edge printing hole 321 in the third direction Y2 is greater than the maximum size D7 of the middle printing hole 322 in the third direction Y2. In this way, the electrical connection material layer printed by the edge printing hole 321 has a relatively large size, and the electrical connection material layer is filled between the edge electrical connection portion having a relatively large size and the conductive wire, so that the edge electrical connection portion fully contacts the conductive wire and forms a bonding structure having a relatively large size, thereby facilitating an improvement in the thermal cycle reliability of the photovoltaic module.

Referring to Fig. 13 and Fig. 14, among the printing holes 32 in the same column, there are a plurality of edge printing holes 321, the plurality of edge printing holes 321 include a first edge printing hole 3211 and second edge printing holes 3212, the first edge printing hole 3211 is an edge printing hole 321 among the plurality of edge printing holes 321 that is farthest away from the screen middle region 311, a maximum size of the first edge printing hole 3211 in the third direction Y2 is D61, and a maximum size of the second edge printing hole 3212 in the third direction Y2 is D62, and D61>D62.

Considering that the maximum size of the first edge electrical connection portion in the first direction is greater than the maximum size of the second edge electrical connection portion in the first direction, in order to match the size of an electrical connection material layer printed by the edge printing hole 321 with the size of the corresponding edge electrical connection portion, the maximum size D61 of the first edge printing hole 3211 in the third direction Y2 is greater than the maximum size D62 of the second edge printing hole 3212 in the third direction Y2. In this way, the electrical connection material layer printed by the first edge printing hole 3211 has a greater size, and the electrical connection material layer is filled between the first edge electrical connection portion 1311 having a relatively large size and the conductive wire 20, so that the first edge electrical connection portion 1311 fully contacts the conductive wire 20 and forms a bonding structure having a relatively large size, thereby facilitating an improvement in the thermal cycle reliability of the photovoltaic module.

In some embodiments, a plurality of columns of printing holes 32 are spaced apart in a fourth direction X2. The fourth direction X2 intersects the third direction Y2.

Finally, it should be noted that the above embodiments are only used to illustrate the technical solutions of the present invention rather than limiting the same. Although the present invention has been described above in detail with reference to the foregoing embodiments, those of ordinary skill in the art should understand that the technical solutions described in the foregoing embodiments may still be modified, or some or all of the technical features may be equivalently replaced; and these modifications or replacements do not make the essence of the corresponding technical solutions depart from the scope of the technical solutions of the embodiments of the present invention.

## Claims

1. A solar cell, comprising:
a cell body (11), having a cell surface (111), wherein the cell surface (111) comprises a middle region (1111) and edge regions (1112) disposed at opposite ends of the middle region (1111) in a first direction (Y1);
a plurality of fingers (12), spaced apart on the cell surface (111), wherein the first direction (Y1) is a direction in which the plurality of fingers (12) are disposed at intervals, and the plurality of fingers (12) comprise a plurality of middle fingers (121) disposed in the middle region (1111) and a plurality of edge fingers (122) disposed in the edge regions (1112); and
a plurality of electrical connection portions (13), comprising a plurality of middle electrical connection portions (132) disposed in the middle region (1111) and a plurality of edge electrical connection portions (131) disposed in the edge regions (1112), wherein each of the plurality of edge electrical connection portions (131) is respectively connected to at least one of the plurality of edge fingers (122), and a maximum size of at least one of the plurality of edge electrical connection portions (131) in the first direction (Y1) is D1; and each of the plurality of middle electrical connection portions (132) is respectively connected to at least one of the plurality of middle fingers (121), a maximum size of at least one of the plurality of middle electrical connection portions (132) in the first direction (Y1) is D2, and D1>D2.

2. The solar cell according to claim 1, wherein the plurality of edge electrical connection portions (131) are disposed in at least one of the edge regions (1112), and a plurality of edge electrical connection portions (131) in a same edge region (1112) comprise a plurality of edge electrical connection portions (131) spaced apart in a column along the first direction (Y1); and
among the plurality of edge electrical connection portions (131) in the column, a part of the plurality of edge electrical connection portions (131) in the column are first edge electrical connection portions (1311), and an other part of the plurality of edge electrical connection portions (131) in the column are second edge electrical connection portions (1312), the second edge electrical connection portions (1312) are closer to the middle region (1111) than the first edge electrical connection portions (1311), a maximum size of each of the first edge electrical connection portions (1311) in the first direction (Y1) is D11, and a maximum size of each of the second edge electrical connection portions (1312) in the first direction (Y1) is D12, wherein D11>D12.

3. The solar cell according to claim 2, wherein the solar cell satisfies at least one of the following:
each of the first edge electrical connection portions (1311) is connected to some of the plurality of edge fingers (122) spaced apart in the first direction (Y1);
in an edge region (1112) provided with edge electrical connection portions (131), a first edge electrical connection portion (1311) is an edge electrical connection portion (131) farthest away from the middle region (1111);
in an edge region (1112) provided with edge electrical connection portions (131), two second edge electrical connection portions (1312) are disposed;
the maximum size D11 of each of the first edge electrical connection portions (1311) in the first direction (Y1) ranges from 0.5mm to 2mm;
the maximum size D12 of each of the second edge electrical connection portions (1312) in the first direction (Y1) ranges from 0.2mm to 0.5mm.

4. The solar cell according to any one of the preceding claims, wherein at least one of the plurality of electrical connection portions (13) is provided with at least one hollow portion (133), and the cell surface (111) is exposed to a setting region of the at least one hollow portion (133).

5. The solar cell according to claim 4, wherein each of the at least one hollow portion (133) penetrates through a respective electrical connection portion (13) in the first direction (Y1); and
a same electrical connection portion (13) is provided with one or more hollow portions (133), in a case where a plurality of hollow portions (133) are disposed on the same electrical connection portion (13), the plurality of hollow portions (133) are spaced apart in a second direction (X1), and the second direction (X1) intersects with the first direction (Y1).

6. The solar cell according to claim 5, wherein the solar cell satisfies at least one of the following:
a size D3 of a hollow portion (133) in the second direction (X1) ranges from 0.1mm to 0.5mm, and the first direction (Y1) is perpendicular to the second direction (X1);
the same electrical connection portion (13) is provided with 2 to 5 hollow portions (133);
the at least one hollow portion (133) is disposed on the plurality of edge electrical connection portions (131).

7. The solar cell according to any one of the preceding claims, wherein at least one of the plurality of electrical connection portions (13) comprises edges, at least one of which is a concave-convex edge (134).

8. The solar cell according to claim 7, wherein the solar cell satisfies at least one of the following:
at least one of the plurality of edge electrical connection portions (131) comprises edges spaced apart in the first direction (Y1), at least one of which is the concave-convex edge (134); and
the concave-convex edge (134) is sawtooth-shaped or curve-shaped.

9. The solar cell according to any one of claims 1 to 8, wherein each of the plurality of fingers (12) is of an intermittent structure or a continuous structure;
in a case where a finger (12) is of the continuous structure, the finger (12) being of the continuous structure extends in a second direction (X1) and penetrates through an electrical connection portion (13) connected to the finger (12), and the second direction (X1) intersects with the first direction (Y1); and
in a case where a finger (12) is of the intermittent structure, the finger (12) being of the intermittent structure comprises a plurality of sub-fingers (125) spaced apart in the second direction (X1), each of the plurality of sub-fingers (125) extends in the second direction (X1), and ends of two adjacent sub-fingers (125) close to each other are connected to a same electrical connection portion (13).

10. The solar cell according to any one of claims 1 to 9, wherein the solar cell satisfies at least one of the following:
the plurality of middle electrical connection portions (132) are respectively connected to the plurality of middle fingers (121) in a one-to-one manner, and the plurality of middle electrical connection portions (132) have a same size;
the size D2 of each of the plurality of middle electrical connection portions (132) in the first direction (Y 1) ranges from 0.1mm to 0.3mm;
each of the plurality of electrical connection portions (13) has a same size D4 in a second direction (X1), and the second direction (X1) is perpendicular to the first direction (Y1);
a size D4 of each of the plurality of electrical connection portions (13) in a second direction (X1) ranges from 0.5mm to 3mm, and the second direction (X1) is perpendicular to the first direction (Y1); and
each of the plurality of electrical connection portions (13) is a bonding pad.

11. The solar cell according to any one of claims 1 to 10, wherein the solar cell satisfies at least one of the following:
the solar cell is a busbar-free solar cell; and
the solar cell is a back-contact solar cell, the cell surface (111) is a backlight surface, a part of the plurality of fingers (12) are positive-electrode fingers (123) and an other part of the plurality of fingers (12) are negative-electrode fingers (124), and the positive-electrode fingers (123) and the negative-electrode fingers (124) are alternately disposed in the first direction (Y1); a part of the plurality of electrical connection portions (13) are positive-electrode electrical connection portions (136), an other part of the electrical connection portions (13) are negative-electrode electrical connection portions (135), each of the positive-electrode electrical connection portions (136) is respectively connected to at least one of the plurality of positive-electrode fingers (123), each of the negative-electrode electrical connection portions (135) is respectively connected to at least one of the plurality of negative-electrode fingers (124), at least one of the plurality of negative-electrode fingers (124) is partially provided with at least one negative-electrode insulation portion (14), at least one of the plurality of positive-electrode fingers (123) is partially provided with at least one positive-electrode insulation portion (15), orthographic projections of the positive-electrode electrical connection portions (136) and orthographic projections of a plurality of negative-electrode insulation portions (14) in the first direction (Y1) coincide, and orthographic projections of the negative-electrode electrical connection portions (135) and orthographic projections of a plurality of positive-electrode insulation portions (15) in the first direction (Y1) coincide.

12. A photovoltaic module, comprising a plurality of conductive wires (20) and a plurality of solar cells (10), wherein the plurality of solar cells (10) are electrically connected to each other by the plurality of conductive wires (20), at least one of the plurality of solar cells (10) is the solar cell (10) according to any one of claims 1 to 11, and at least one of the plurality of conductive wires (20) extends in the first direction (Y1) and is connected to the plurality of edge electrical connection portions (131) and the plurality of middle electrical connection portions (132).

13. The photovoltaic module according to claim 12, wherein the photovoltaic module satisfies at least one of the following:
a width of each of the plurality of conductive wires (20) in the second direction (X1) is D5, a size of each of the plurality of electrical connection portions (13) in the second direction (X1) is D4, and the second direction (X1) is perpendicular to the first direction (Y1), wherein D4>D5; and
each of the plurality of conductive wires (20) is a solder strip.

14. A printing screen for printing an electrical connection material on the solar cell (10) according to any one of claims 1 to 11, wherein the printing screen (30) comprises a printing surface (31), the printing surface (31) is provided with a plurality of printing holes (32), the plurality of printing holes (32) comprise a plurality of printing holes (32) spaced apart in a column along a third direction (Y2), and the printing surface (31) comprises a screen middle region (311) and screen edge regions (312) disposed at opposite ends of the screen middle region (311) in the third direction (Y2); among the plurality of printing holes (32) in the column, a part of the plurality of printing holes (32) in the column are edge printing holes (321) and an other part of the plurality of printing holes (32) in the column are middle printing holes (322), the edge printing holes (321) are disposed in the screen edge regions (312), a maximum size of at least one of the edge printing holes (321) in the third direction (Y2) is D6, the middle printing holes (322) are disposed in the screen middle region (311), and a maximum size of at least one of the middle printing holes (322) in the third direction (Y2) is D7, wherein D6>D7.

15. The printing screen according to claim 14, wherein among the plurality of printing holes (32) in the column, there are a plurality of edge printing holes (321), the plurality of edge printing holes (321) comprise a first edge printing hole (3211) and at least one second edge printing hole (3212), the first edge printing hole (3211) is an edge printing hole (321) among the plurality of edge printing holes (321) that is farthest away from the screen middle region (311), a maximum size of the first edge printing hole (3211) in the third direction (Y2) is D61, and a maximum size of a second edge printing hole (3212) in the third direction (Y2) is D62, wherein D61>D62.
